# EUROPÄISCHE PATENTSCHRIFT

(11) **EP 0 686 316 B1**
(45) Veröffentlichungstag und Bekanntmachung des Hinweises auf die Patenterteilung: **20.11.1996**
(21) Anmeldenummer: 94909014.6
(22) Anmeldetag: 21.02.1994
(51) Int. Cl.: H02B 1/30, H02B 1/01

(54) **SCHRANK**
CABINET
ARMOIRE

(30) Priorität: 25.02.1993 DE 9302769 U
(43) Veröffentlichungstag der Anmeldung: 13.12.1995
(73) Patentinhaber: KNÜRR-MECHANIK FUR DIE ELEKTRONIK AKTIENGESELLSCHAFT, D-81829 Munchen (DE)
(72) Erfinder: SIMON, Peter, D-81377 München (DE); FLAMME, Hans, D-82008 Unterhaching (DE); STREIFENEDER, Robert, D-94431 Pilsting (DE); HECKNER, Helmut, D-94474 Vilshofen (DE)
(74) Vertreter: Heim, Hans-Karl, Dipl.-Ing.
(86) Internationale Anmeldenummer: EP9400496
(87) Internationale Veröffentlichungsnummer: WO9419850

(56) Entgegenhaltungen:
- EP-A- 0 045 926
- EP-A- 0 158 216
- EP-A- 0 389 910
- EP-A- 0 428 335
- DE-A- 3 401 468
- DE-A- 4 119 435
- DE-U- 9 302 769
- GB-A- 2 212 879
- US-A- 4 691 970

## Beschreibung

Die Erfindung betrifft einen Schrank zur Aufnahme elektrischer und elektronischer Geräte und Baugruppen gemäß dem Oberbegriff des Anspruchs 1.

Derartige Schränke, die als 19-Zoll-Schränke, Schalt- und Geräteschränke bekannt sind, ermöglichen vielfältige Ein- und Anbaukonzeptionen und Gestaltungsvarianten und sind zum Aufbau von Schrank- und Gehäusesystemen geeignet.

Aus der EP 0 389 910 A1 ist ein Geräteschrank bekannt, der ein Rahmengestell aus Vertikal-, Horizontal- und Querprofilleisten aufweist, welche mit in Längsrichtung verlaufenden und im Querschnitt schlüssellochförmig ausgebildeten Nuten versehen sind. Die Profilleisten sind über Eckverbinder miteinander verbunden, indem jeweils zwei sich diagonal gegenüberstehende Zapfen einer Eckverbinderfläche in die Nuten oder weitere Bohrungen an den Stirnseiten der Profilleisten eingreifen. In Abhängigkeit vom Einsatzort und Verwendungszweck wird ein derartiges Rahmengestell mit einer ober- und bodenseitigen Abdeckung und mit Seitenwänden verkleidet sowie mit einer Rückwand oder mit einer rückseitigen Tür und mit einem frontseitigen Rahmen oder einer Tür versehen.

Ein IP-dichter und HF-abgeschirmter Geräteschrank der EP 0 428 335 A2 weist als Rahmengestell ebenfalls Profilleisten auf, die über Eckverbinder verbunden sind. An den Profilholmen ist ein Dichtungssteg zur Aufnahme eines elastischen HF-Dichtungsbandes ausgebildet. Ein Nachteil ist die unterschiedliche Profilausbildung der Vertikalholme im Vergleich zu den quer und horizontal angeordneten Holmen.

Aus der USPS 4 691 970 ist ein staubdicht ausgebildeter Gehäuseschrank bekannt, dessen Rahmenprofile mit wenigstens einem nach außen gerichteten Dichtungssteg versehen sind. Um für jedes Verkleidungsteil, für Seitenwände, Boden- und Deckplatte einen umlaufenden Dichtungssteg zu erreichen, sind auch die Eckverbinder mit nach außen abstehenden Dichtungsstegen versehen. Bei der Montage der Verkleidungsteile wird ein endloses Dichtungsprofil zwischen den an den Rahmenprofilen und den zugehörigen Eckverbindern ausgebildeten umlaufenden Dichtungssteg und das jeweilige Verkleidungsteil angeordnet. Die Eckverbinder weisen in Raumkoordinatenrichtung Führungselemente auf, in welche zusätzliche Spreizelemente eingeführt werden, um die Profilleisten zu fixieren.

Diese bekannten Schränke oder Schrankgehäuse entsprechen im Hinblick auf eine sichere und stabile Konstruktion nicht in jedem Fall den jeweiligen Anforderungen. Außerdem wirkt sich der erforderliche Herstellungs- und Montageaufwand nachteilig auf die Kosten aus.

Der Erfindung liegt die **Aufgabe** zugrunde, eine besonders stabile und sichere Schrankkonstruktion zu schaffen, die gleichzeitig eine außerordentlich effiziente Fertigung und Montage ermöglicht.

Erfindungsgemäß wird die Aufgabe durch die kennzeichnenden Merkmale des Anspruchs 1 gelöst. Vorteilhafte und zweckmäßige Ausgestaltungen sind in den Unteransprüchen und in der Figurenbeschreibung enthalten.

In einer fertigungs- und montagegünstigen Ausbildung der Profilleisten und der Eckverbinder, welche mit Führungselementen zum Aufstecken und mit Durchgangsbohrungen zum Befestigen der Profilleisten mit Hilfe von Befestigungselementen versehen sind, wobei die Befestigung der aufgesteckten Profilleisten mit in den Durchgangsbohrungen der Eckverbinder geführten Befestigungselementen vorgenommen wird, welche jeweils in einen zweiten Hohlraum der Profilleisten eingeführt und gesichert werden, wird eine besonders wirkungsvolle form- und kraftschlüssige Verbindung der Profilleisten an deren Stirnseiten dadurch erreicht, daß ein an den Profilleisten angeordneter Dichtungssteg als Verlängerung einer an den Schrankinnenraum angrenzenden Innenwand des Hohlprofils der Profilleisten ausgebildet ist und daß die mit Aufnahmeflächen für die Profilleisten versehenen Eckverbinder horizontale Aufnahmeflächen aufweisen, welche deckungsgleich zum Querschnitt der Profilleisten ausgebildet und mit einem keilförmigen Bereich zur Auflage des Dichtungssteges der vertikalen Profilleisten versehen sind. Eine besonders effiziente Montage des Geräteschrankes bzw. des Gehäuses wird dadurch erreicht, daß jeder Eckverbinder einen zusätzlichen Aufnahmebereich zur Halterung einer Bodenplatte oder einer Deckplatte und zur Befestigung von Standfüßen oder eines Sockels aufweist. Dieser Aufnahmebereich steht in vertikaler Richtung nach außen und in horizontaler Richtung nach innen zum Schrankinnenraum über und bildet einen zusätzlichen Bereich des Eckverbinders, der zudem eine besonders gute Zugänglichkeit der Verbindungselemente gewährleistet.

Die Führungselemente der Eckverbinder sind insbesondere blockartig, beispielsweise quaderförmig, an den Anschlußflächen der Eckverbinder ausgebildet und ermöglichen im Zusammenwirken mit einem ersten, komplementär ausgebildeten Hohlraum der Profilleisten, insbesondere mit einer stirnseitigen Öffnung einer T-Nut, ein schnelles Aufstecken der Profilleisten mit Vorpositionierung.

Vorteilhaft ist die Verwendung von hohlen Eckverbindern, die als Druckgußteile kostengünstig zu fertigen sind. Eine besonders stabile Verbindung zwischen den Eckverbindern und Profilleisten wird mit Hilfe von Verbindungsschrauben erreicht, die mit einem glatten Schaft nahezu formschlüssig in gewindefreien Durchgangsbohrungen der Eckverbinder geführt sind und mit einem selbstschneidenden Gewinde in einen inbesondere zentral angeordneten, kreisförmigen Kanal der Profilleisten eingeschraubt werden.

Vorteilhafterweise wird beim Eindrehen einer Verbindungsschraube in den mit einer glatten Wandung versehenen Kanal eine präzise Ausrichtung der Profilleisten erreicht.

Für die Montage der Verkleidungsteile und für eine ungehinderte Öffnungsbewegung einer Tür ist eine versenkte Aufnahme der Verbindungselemente zweckmäßig. Eine leichte Handhabung der Befestigungselemente, beispielsweise von Senkkopfschrauben,ist dadurch erreicht, daß diese von Außenflächen der Eckverbinder aus zugänglich sind. Die Außenflächen der Eckverbinder verlaufen parallel zu den Anschlußflächen, welche die stirnseitigen Enden der Profilleisten aufnehmen.

Die Anschlußflächen, an denen die Führungselemente insbesondere überstehend angeordnet sind, werden im Bereich der Austrittsöffnungen der Durchgangsbohrungen mit Ansenkungen versehen. In diesen Ansenkungen kann der Materialaufwurf, der beim Eindrehen der Verbindungsschrauben in die zentralen Kanäle der Profilleisten entsteht, aufgenommen werden.

Eine stabile Schrank- oder Gehäusekonstruktion ist dadurch gewährleistet, daß wenigstens die horizontalen Anschlußflächen deckungsgleich zu den angrenzenden vertikalen Profilleisten ausgebildet sind. Der Dichtungssteg, der als Verlängerung der Innenseite eines nahezu rechteckigen Hohlprofils ausgebildet und jeweils vom Schrankinnenraum weggerichtet ist, liegt auf einem keilförmig ausgebildeten Bereich des Eckverbinders auf bzw. grenzt an diesen an.

Zur Halterung von bodenseitigen und deckenseitigen Abdekkungen, beispielsweise einer Boden- und Deckplatte oder eines Boden- und Deckbleches, sind an den Eckverbindern Aufnahmebereiche ausgebildet, die in vertikaler Richtung nach außen und in horizontaler Richtung nach innen, bezogen auf den Schrank bzw. auf das Rahmengestell, überstehen. Die Aufnahmebereiche weisen Befestigungsbereiche, beispielsweise wenigstens eine Gewindebohrung für eine Schraubbefestigung auf, um eine Deckplatte bzw. eine Bodenplatte fixieren zu können oder um die Aufnahme von Tellerfüßen, Nivellierfüßen oder eines Sockels zu ermöglichen.

In einer bevorzugten Ausgestaltung der Erfindung ist der Schrank auf einen Sockel abgestützt, der zur Aufnahme der Kräfte, insbesondere der Vertikalkräfte, im Bereich der Eckverbinder Sockeleckteile aufweist. In einer kostengünstigen Fertigung sind die Sockeleckteile aus einem insbesondere einstückigen, metallischen Flachmaterial, beispielsweise aus Stahlblech oder Aluminiumblech, hergestellt. Durch einen entsprechenden Zuschnitt und Abwinklungen werden zwei, in einem Winkel von 90 Grad angeordnete Schenkel gebildet, die eine obere, beispielsweise verschweißte Eckenaufnahme zur Aufnahme der Eckverbinder aufweisten. Die Eckenaufnahme ist auf beidseitig und doppellagig ausgebildeten, vertikalen Stützstegen abgestützt, so daß über die aufliegenden, insbesondere festgeschraubten Eckverbinder eine außerordentlich hohe Stabilität erreicht wird.

Der Querschnitt der Sockeleckteile bzw. deren Schenkel ist nahezu S-förmig und durch ein oberes, nach außen offenes U-Profilteil und ein unteres, ins Schrankinnere gerichtetes U-Profilteil gebildet.

Zwischen den Sockeleckteilen sind als Verblendungen Sockelelemente angeordnet, die über Verbindungsflansche an den Sockeleckteilen lösbar zu befestigen sind. Die insbesondere aus Aluminium-Strangpreßprofilen abgelängten Profilleisten des Rahmengestells, die T-Nuten, insbesondere zur Befestigung von Modulschienen für Schrankeinbauten, Geräte und Baugruppen, aber auch für Türscharniere, aufweisen, ermöglichen außerdem eine besondere einfache Montage und Sicherung der Seitenwände und gegebenenfalls der Rückwand.

Die Seitenwände, die zweckmäßigerweise mit abgewinkelten Randleisten versehen sind, werden jeweils in die oberen Profilleisten eingehängt und umgreifen die vertikalen und die bodenseitigen horizontalen Profilleisten. Aus Sicherheitsgründen und unter dem Aspekt einer Produkthaftung sind in den Randbereichen der Seitenwände Schnellverschlüsse und im Bereich der unteren Kante ein Vorreiber, beispielsweise mit Schließzylinder, vorgesehen, so daß die Seitenwände und/oder die Rückwand von nicht befugten Personen nicht anzuheben und auszuhängen sind.

Vorteilhaft ist die Montage einer zusätzlichen, insbesondere horizontalen Multifunktionsschiene zwischen den Profilleisten, insbesondere im mittleren Bereich der Seitenwände. Dadurch werden neue, zusätzliche Einbauvarianten ermöglicht. Außerdem wird eine verbesserte Abstützung der Einbauten und des gesamten Schrankgestelles erreicht.

Die Erfindung wird nachstehend anhand einer Zeichnung weiter beschrieben; in dieser zeigen:
- Fig. 1: in einer Explosionszeichnung einen erfindungsgemäßen Schrank;
- Fig. 2: in einer Explosionszeichnung einen Auschnitt des Rahmengestells im Bereich eines Eckverbinders;
- Fig. 3: eine perspektivische ausschnittsweise Darstellung eines Sockels;
- Fig. 4: einen vertikalen Schnitt eines Sockeleckteils längs der Linie IV-IV in Figur 5 und
- Fig. 5: eine Draufsicht auf ein Doppeleckteil gemäß Pfeil V in Figur 4.

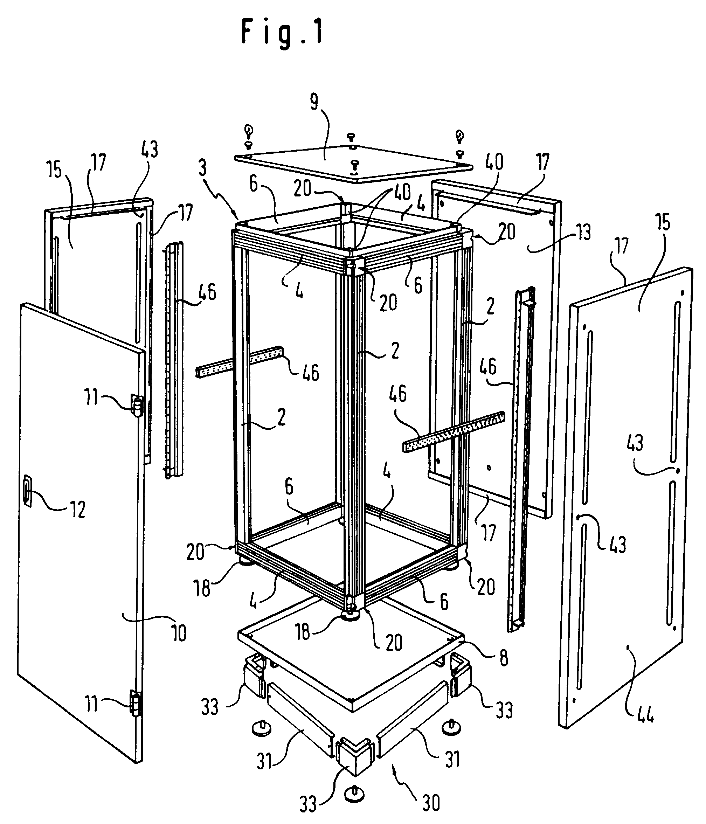

In Figur 1 ist in einer Explosionszeichnung ein Schrank für Baugruppen und Geräte dargestellt, der ein Rahmengestell 3 mit vier Vertikalprofilleisten 2, oberen und unteren Horizontalprofilleisten 4 und Querprofilleisten 6 sowie als Verkleidungsteile eine Bodenplatte 8, eine Deckplatte 9, zwei Seitenwände 15, eine Rückwand 13 und eine Tür 10 aufweist. Als Verkleidungsteile werden beispielsweise lackierte Stahlbleche verwendet, an denen rundumlaufende Randleisten 17 abgewinkelt sind. Im Zusammenwirken mit den Profilleisten 2, 4, 6 und Eckverbindern 20, an denen die Profilleisten 2, 4, 6 in Raumkoordinatenrichtung befestigt sind, kann eine Abdichtung gegen Staub, Wasser und Fremdkörper und bei unlackierten Randleisten 17 und mittels Kontaktstreifen ein HF-Abschirmung der nahe aneinandergrenzenden Verkleidungsteile erreicht werden. Die Seitenwände 15 und gegebenenfalls auch die Rückwand 17 können mit Schnellverschlüssen 43 und, beispielsweise in einem bodenseitigen Bereich, mit einem Vorreiber 44 mit Schließzylinder ausgestattet sein, um ein unberechtigtes Aushängen zu verhindern. Die frontseitige Tür 10, die aus Acrylglas bestehen kann, weist Türscharnierteile 11 auf, die lösbar mit schrankseitigen, an einer Vertikalprofilleiste 2 befestigten Türscharnierteilen (nicht dargestellt) zu verbinden sind. Die Tür ist außerdem mit einer Schließvorrichtung versehen, von der ein Türschild 12 mit Griff dargestellt ist.

Im Bereich der Seitenwände 15 können Multifunktionsschienen 46 zwischen horizontalen Profilleisten 4 und/oder vertikalen Profilleisten 2 angebracht sein.

Die Profilleisten 2, 4, 6 sind über Eckverbinder 20 miteinander zu dem Rahmengestell 3 verbunden. Die Eckverbinder 20 sind mit überstehenden Aufnahmebereichen 40 versehen, an denen die Deckplatte 9 und die Bodenplatte 8, beispielsweise über Schraubverbindungen, zu befestigen sind. Mit der Bodenplatte 8 können Tellerfüße 18 oder ein Sockel 30 an den bodenseitigen Eckverbindern 20 fixiert werden.

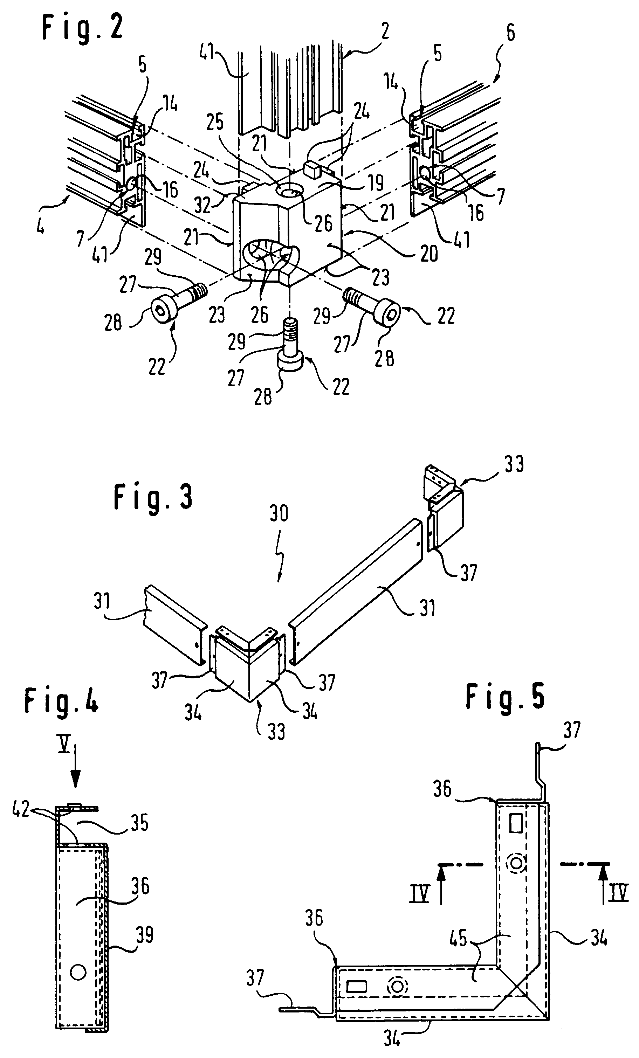

Figur 2 zeigt die Ausbildung eines Eckverbinders 20 in einer vergrößerten Darstellung. Der aus einem hohlen Aluminium-Druckgußteil bestehende Eckverbinder 20 ist in Raumkoordinatenrichtung mit drei Anschlußflächen 21 und blockartigen, quaderförmigen Führungselementen 24 und mit Durchgangsbohrungen 26 zur Aufnahme von Befestigungselementen 22 versehen. Als Befestigungselemente 22 werden in diesem Ausführungsbeispiel Verbindungsschrauben 28 mit einem glatten, in den Durchgangsbohrungen 26 anliegenden Schaft 27 und mit einem selbstschneidenden Gewinde 29 am vorderen Schaft verwendet, die in einen stirnseitigen, zweiten Hohlraum 7, insbesondere in einen zentralen kreisförmigen Kanal 16, der Profilleisten 2, 4, 6 unter Ausrichtung der Profilleisten einzuschrauben sind. Die Durchgangsbohrungen 26 sind an ihren Austrittsöffnungen mit Ansenkungen 25 versehen, in denen die beim Einschrauben anfallenden Späne oder ein Materialaufwurf aufgenommen werden können.

Beim stirnseitigen Aufstecken der Aluminium-Spritzgußprofilleisten 2, 4, 6 gelangen die überstehenden Führungselemente 24 in Eingriff mit stirnseitigen Öffnungen von T-Nuten 14, die komplementär zu den Führungselementen 24 einen rechteckigen Querschnitt aufweisen. Aus Figur 2 wird deutlich, daß die horizontalen Aufnahmeflächen 19 des Eckverbinders 20 deckungsgleich zum Querschnitt der Profilleisten 2, 4, 6 ausgebildet sind und daß keilförmige Bereiche 32 die Dichtungsstege 41 der vertikalen Profilleisten 2 aufnehmen.

Die Befestigungselemente 22 werden von Außenflächen 23 her in die Durchgangsbohrungen 26 eingeführt. Die Aufnahmebereiche 40, welche jeweils an den zu den horizontalen Profilleisten 4 gerichteten Aufnahmeflächen 21 ausgebildet sind, sind bei dieser Darstellung nicht sichtbar (vgl. dazu Figur 1).

Aus den Figuren 3, 4 und 5 geht die Ausbildung eines Sokkels 30 hervor. In Figur 3 ist der Sockel 30 mit Sockeleckteilen 33 und zwischen den Sockeleckteilen 33 zu befestigenden Sockelelementen 31 dargestellt. Die Sockelelemente 31 sind U-Profile, die mit ihren stirnseitigen Ausnehmungen auf Verbindungsflansche 37 der Sockeleckteile 33 aufschiebbar und fixierbar sind.

Die Sockeleckteile 33 sind als stabile Stützelemente ausgebildet und in einer fertigungstechnisch vorteilhaften Weise aus einem Zuschnitt eines Stahlbleches gefalzt. Die Sockeleckteile 33 sind, wie insbesondere aus Figur 1 hervorgeht, unterhalb der Eckverbinder 20, insbesondere zur Aufnahme der vertikalen Kräfte angeordnet. Zur Lastaufnahme sind die aus zwei rechtwinklig zueinander abgebogenen Schenkeln 34 bestehenden Sockeleckteile 33 im Querschnitt S-förmig ausgebildet (Fig. 4). An ein oberes, nach außen offenes U-Profilteil 35 mit Durchführungsöffnung 42 zum Verbinden der Sockeleckteile 33 und der Eckverbinder 20 schließt sich ein unteres U-Profilteil 39 an. Am oberen Profilteil 35 ist eine Eckenaufnahme 45 beispielsweise durch Verschweißen der Ränder einer Ausnehmung gebildet, die nach dem Abbiegen des einstückigen Flachmaterials aneinanderliegen. Auf der Ekkenaufnahme 45 sind die Eckverbinder 20 mit aufliegenden vertikalen Profilleisten 2 abgestützt. Eine besonders hohe Stabilität wird durch doppellagige vertikale Stützstege 36 erreicht, die an den Schenkelenden und über die gesamte Tiefe des oberen Profilteils 35 durch eine Doppelfalzung gebildet sind.

## Patentansprüche

1. Schrank zur Aufnahme von elektrischen und elektronischen Geräten und Baugruppen, mit vertikalen (2), horizontalen (4) und quer angeordneten Profilleisten (6), die als Hohlprofil mit einem nahezu rechteckigen Querschnitt und mit einem Dichtungssteg (41) ausgebildet sind und über Eckverbinder (20), welche wenigstens horizontale Aufnahmeflächen (19) aufweisen, zu einem Rahmengestell (3) verbunden sind, welches mit Verkleidungsteilen, insbesondere Boden- (8) und Deckplatte (9), Tür (10), Rückwand (13) und Seitenwänden (15), ausstattbar ist, wobei jeder Eckverbinder (20) in Raumkoordinatenrichtung Führungselemente (24) und Durchgangsbohrungen (26) aufweist und jedes Führungselement (24) zum stirnseitigen Aufstecken einer Profilleiste (2, 4, 6) komplementär zu einem ersten Hohlraum (5) der Profilleiste (2, 4, 6) ausgebildet ist und in den Durchgangsbohrungen (26) Befestigungselemente (22) geführt sind, die in einem zweiten Hohlraum (7) der Profilleisten (2, 4, 6) fixierbar sind,
dadurch **gekennzeichnet**,
daß die Profilleisten (2, 4, 6) einen gleichen Querschnitt aufweisen,
daß der Dichtungssteg (41) der Profilleisten (2, 4, 6) als Verlängerung einer an den Schrankinnenraum angrenzenden Innenwand des Hohlprofils ausgebildet ist,
daß die horizontalen Aufnahmeflächen (19) der Eckverbinder deckungsgleich zum Querschnitt der Profilleisten (2, 4, 6) ausgebildet und mit einem keilförmigen Bereich (32) zur Auflage des Dichtungssteges (41) der vertikalen Profilleisten (2) versehen sind und daß jeder Eckverbinder (20) einen Aufnahmebereich (40) zur Halterung der Bodenplatte (8) oder der Deckplatte (9) und zur Befestigung von Standfüßen (42) oder eines Sockels (30) aufweist, wobei der Aufnahmebereich (40) in vertikaler Richtung nach außen und in horizontaler Richtung nach innen zum Schrankinnenraum übersteht.

2. Schrank nach Anspruch 1,
dadurch **gekennzeichnet**,
daß jeder Eckverbinder (20) als hohles Druckgußteil ausgebildet ist und im Bereich von Anschlußflächen (21) für die Profilleisten (2, 4, 6) blockartig ausgebildete Führungselemente (24) aufweist, auf welche die Profilleisten (2, 4, 6) mit einer stirnseitigen Öffnung einer T-Nut (14) aufsteckbar sind.

3. Schrank nach Anspruch 1 oder 2,
dadurch **gekennzeichnet**,
daß die Durchgangsbohrungen (26) von Außenflächen (23), insbesondere des keilförmigen Bereiches (32) der Eckverbinder (20) aus zugänglich und zur versenkten Aufnahme von Verbindungsschrauben (28) als Befestigungselementen (22) ausgebildet sind.

4. Schrank nach Anspruch 2 oder 3,
dadurch **gekennzeichnet**,
daß die Austrittsöffnungen der Durchgangsbohrungen (26) an den Anschlußflächen (21) der Eckverbinder (20) ausgebildet und mit Ansenkungen (25) versehen sind.

5. Schrank nach Anspruch 3,
dadurch **gekennzeichnet**,
daß die Verbindungsschrauben (28) einen glatten Schaft (27) und ein selbstschneidendes Gewinde (29) aufweisen und mit dem glatten Schaft (27) in den Durchgangsbohrungen (26) geführt und mit dem selbstschneidenden Gewinde (29) in einen zentralen, kreisförmigen Kanal (16) als zweiten Hohlraum (7) der Profilleisten (2, 4, 6) einschraubbar sind.

6. Schrank nach einem der Ansprüche 1 bis 5,
dadurch **gekennzeichnet**,
daß jeder Aufnahmebereich (40) des Eckverbinders (20) zur Befestigung des Sockels (30) ausgebildet ist.

7. Schrank nach Anspruch 1,
dadurch **gekennzeichnet**,
daß der Sockel (30) im Bereich der Eckverbinder (20) Sockeleckteile (33) zur Aufnahme von insbesondere Vertikalkräften aufweist.

8. Schrank nach Anspruch 7,
dadurch **gekennzeichnet**,
daß die Sockeleckteile (33) aus einem Flachmaterial hergestellt sind.

9. Schrank nach Anspruch 7 oder 8,
dadurch **gekennzeichnet**,
daß die Sockeleckteile (33) aus einem einstückigen metallischen Flachmaterial hergestellt sind.

10. Schrank nach einem der Ansprüche 7 bis 9,
dadurch **gekennzeichnet**,
daß die Sockeleckteile (33) zwei rechtwinklig abgebogene Schenkel (34) mit doppellagigen, vertikalen Stützstegen (36) aufweisen, auf denen ein oberes Profilteil (35) des Sockeleckteils (33) abgestützt ist.

11. Schrank nach Anspruch 10,
dadurch **gekennzeichnet**,
daß das obere Profilteil (35) ein nach außen offenes U-Profil mit einer durch eine Ausnehmung in dem Flachmaterial gebildeten Eckenaufnahme (45) ist, welches mit einem unteren U-Profilteil (39) einen nahezu S-förmigen Querschnitt des Sockeleckteils (33) bildet.

12. Schrank nach einem der vorhergehenden Ansprüche 7 bis 11,
dadurch **gekennzeichnet**,
daß an den Schenkeln (34) der Sockeleckteile (33) Verbindungsflansche (37) zum Einführen in die Sockeleckteile (33) verbindende Sockelelemente (31) ausgebildet sind.

13. Schrank nach einem der vorhergehenden Ansprüche,
dadurch **gekennzeichnet**,
daß die Seitenwände (15) und/oder die Rückwand (13) abgewinkelte Randleisten (17) aufweisen, die eine Ausnehmung, insbesondere eine T-Nut, der oberen und unteren horizontalen Profilleisten (4) bzw. querverlaufenden Profilleisten (6) hintergreifen, und daß eine Abdichtung an den Profilstegen (41) an der Innenwand der Profilleisten (2,4,6) erfolgt.

14. Schrank nach einem der vorhergehenden Ansprüche,
dadurch **gekennzeichnet**,
daß wenigstens die Seitenwände (15) seitliche Schnellverschlüsse (43) und bodenseitige Vorreiber, die insbesondere mit Schließzylindern (44) versehen sind, aufweisen.

15. Schrank nach einem der vorhergehenden Ansprüche,
dadurch **gekennzeichnet**,
daß die Profilleisten (2,4,6) aus abgelängten Strangpreßprofilen bestehen und daß an den vertikalen Profilleisten (2) und/oder an den horizontalen Profilleisten (6) Multifunktionsschienen (46), insbesondere im mittleren Bereich der Seitenwände (15), fixierbar sind.

## Claims

1. Cabinet for receiving electrical and electronic equipment and subassemblies, with vertically (2 ), horizontally (4) and transversally arranged sectional bars (6), which are constructed as hollow sections with an almost rectangular cross-section and with a sealing web (41) and are connected by means of corner connectors (20), which have at least horizontal reception surfaces (19), to a framework (3), which can be equipped with cladding parts, particularly bottom (8)and top (9) plates, door (10), rear wall (13) and side walls (15), each corner connector (20) having in the space coordinate direction guide elements (24) and through bores (26) and each guide element (24) for the frontal mounting of a sectional bar (2, 4, 6) is constructed in complementary manner to a first cavity (5) of the sectional bar (2, 4, 6) and in the through bores (26) are guided fixing elements (22), which can be fixed in a second cavity (7) of the sectional bars (2, 4, 6),
**characterized** in that
the sectional bars (2, 4, 6) have a same cross-section, that the sealing web (41) of the sectional bars (2, 4, 6) is constructed as extension of an inside wall of the hollow section, the inside wall being adjacent to the cabinet interior,
that the horizontal reception surfaces (19) of the corner connectors are constructed congruently to the cross-section of the sectional bars (2, 4, 6) and are provided with a wedge-shaped area (32) for supporting the sealing web (41) of the vertical sectional bars (2), and
that each corner connector (20) has a reception area (40) for retaining the bottom plate (8) or the top plate (9) and for fixing support feet (42) or a base (30), the reception area (40) projecting vertically outwards and horizontally inwards relative to the cabinet interior.

2. Cabinet according to claim 1,
**characterized** in that
each corner connector (20) is constructed as a hollow pressure diecasting and in the area of the connecting faces (21) for the sectional bars (2, 4, 6) has block-like formed guide elements (24) on which can be slipped-on the sectional bars (2, 4, 6), with a frontal opening of a T-groove (14).

3. Cabinet according to claim 1 or 2,
**characterized** in that
the through bores (26) are accessible from the outer faces (23), particularly of the wedge-shaped area (32) of the corner connectors (20) and are constructed for the countersunk reception of assembly screws (28) as fixing elements (22).

4. Cabinet according to claim 2 or 3,
**characterized** in that
the outgoing openings of the through bores (26) are constructed on the connecting faces (21) of the corner connectors (20) and are provided with countersinks (25).

5. Cabinet according to claim 3,
**characterized** in that
the assembly screws (28) have a smooth shank (27) and a self-tapping thread (29) and with the smooth shank (27) are guided in the through bores (26) and can be screwed with the self-tapping thread (29) into a central, circular channel (16) as second cavity (7) of the sectional bars (2, 4 , 6).

6. Cabinet according to one of the claims 1 to 5,
**characterized** in that
each reception area (40) of the corner connector (20) is constructed for the fixing of the base (30).

7. Cabinet according to claim 1,
**characterized** in that
in the vicinity of the corner connectors (20), the base (30) has base corner parts (33) for retaining in particular vertical forces.

8. Cabinet according to claim 7,
**characterized** in that
the base corner parts (33) are made from a flat material.

9. Cabinet according to claim 7 or 8,
**characterized** in that
the base corner parts (33) are made from a one-piece, metallic flat material.

10. Cabinet according to one of the claims 7 to 9,
**characterized** in that
the base corner parts (33) have two legs (34) bent at right angles with double-sheet, vertical support webs (36), on which is supported an upper sectional part (35) of the base corner part (33).

11. Cabinet according to claim 10,
**characterized** in that
the upper sectional part (35) is an outwardly open U-section with a corner reception (45) formed by a recess in the flat material and which with a lower U-sectional part (39) forms an almost S-shaped cross-section of the base corner part (33).

12. Cabinet according to one of the preceding claims 7 to 11,
**characterized** in that
on the legs (34) of the base corner parts (33) are formed connecting flanges (37) for insertion in the base elements (31) connecting the base corner parts (33).

13. Cabinet according to one of the preceding claims,
**characterized** in that
the side walls (15) and/or the rear wall (13) have bent marginal ledges (17), which engage behind a recess, particularly a T-groove, of the upper and lower horizontal sectional bars (4) respectively the transverse sectional bars (6) and that a sealing is obtained on the profile webs (41) on the inside wall of the sectional bars (2, 4, 6).

14. Cabinet according to one of the preceding claims,
**characterized** in that
at least the side walls (15) are provided with lateral quick acting closures (43) and bottom-side turn-buckles, which in particular have lock cylinders (44).

15. Cabinet according to one of the preceding claims,
**characterized** in that
the sectional bars (2, 4, 6) are made from extruded sections which have been cut to length and that on the vertical sectional bars (2) and/or on the horizontal sectional bars (6) can be fixed multifunction rails (46), particularly in the central area of the side walls (15).

## Revendications

1. Armoire destinée à recevoir des appareils et modules électriques et électroniques, avec des barres profilées verticales (2), horizontales (4) et disposées transversalement (6), qui sont conformées en profilés creux à section presque carrée et avec une baguette d'étanchéité (41), et qui sont reliées, par l'intermédiaire de raccords d'angle (20) qui présentent au moins des surfaces de réception horizontales (19), à un châssis (3), lequel peut être équipé de pièces d'habillage, notamment d'une plaque de fond (8) et de couverture (9), d'une porte (10), d'une paroi arrière (13) et de parois latérales (15), chaque raccord d'angle (20) présentant, dans les directions des coordonnées de l'espace, des éléments de guidage (24) et des perçages traversants (26), et chaque élément de guidage (24), pour permettre l'enfoncement frontal d'une barre profilée (2, 4, 6), étant conformé complémentaire à un premier creux (5) de la barre profilée (2, 4, 46) et des éléments de fixation (22) étant passés dans les perçages traversants (26), éléments qui peuvent se fixer dans un deuxième creux (7) de la barre profilée (2, 4, 6), ***caractérisée en ce que*** les barres profilées (2, 4, 6) présentent une même section transversale, ***en ce que*** la baguette d'étanchéité (41) des barres profilées (2, 4, 6) est conformée en tant que prolongement d'une paroi intérieure du profilé creux contiguë à l'espace intérieur de l'armoire, ***en ce que*** les surfaces de réception horizontales (19) des raccords d'angle étant conformées en coïncidence à la section transversale des barres profilées (2, 4, 6) et étant munies d'une zone en forme de coin (32) destinée à recevoir la baguette d'étanchéité (41) des barres profilées verticales (2), et ***en ce que*** chaque raccord d'angle (20) présente une zone de réception (40) pour le maintien de la plaque de fond (8) ou de la plaque de couverture (9) et pour la fixation de pieds (42) ou d'un socle (30), la zone de réception (40) formant saillie vers l'extérieur dans la direction verticale et vers l'intérieur dans la direction horizontale en direction de l'intérieur de l'armoire.

2. Armoire selon la Revendication 1, ***caractérisée en ce que*** chaque raccord d'angle (20) est conformé en pièce creuse injectée sous pression et présente au niveau de la surface de raccordement (21) pour les barres profilées (2, 4, 6) des éléments de guidage (24) conformés à la manière de blocs, sur lesquels peuvent s'enfoncer les barres profilées (2, 4, 6) avec une ouverture frontale d'une rainure en T (14).

3. Armoire selon la Revendication 1 ou 2, ***caractérisée en ce que*** les perçages traversants (26) sont accessibles depuis des surfaces extérieures (23), notamment de la zone (32) en forme de coin, des raccords d'angle (20) et sont conformés pour recevoir en les noyant des vis de liaison (28) servant d'éléments de fixation (22).

4. Armoire selon la Revendication 2 ou 3, ***caractérisée en ce que*** les ouvertures de sortie des passages traversants (26) sont formées sur les surfaces de raccordement (21) des raccords d'angle (20) et sont munies de renfoncements (25).

5. Armoire selon la Revendication 3, ***caractérisée en ce que*** les vis de liaison (28) présentent une tige lisse (27) et un filet autotaraudeur (29), et passent avec la tige lisse (27) dans les perçages traversants (26) et se vissent avec le filet autotaraudeur (29) dans un canal circulaire central (16) servant de deuxième creux (7) des barres profilées (2, 4, 6).

6. Armoire selon l'une des Revendications 1 à 5, ***caractérisée en ce que*** chaque zone de réception (40) du raccord d'angle (20) est conformée pour servir à la fixation du socle (30).

7. Armoire selon la Revendication 1, ***caractérisée en ce que*** le socle (30) présente, au niveau des raccords d'angle (20), des pièces d'angle de socle (33) pour supporter en particulier des efforts verticaux.

8. Armoire selon la Revendication 7, ***caractérisée en ce que*** les pièces d'angle de socle (33) sont fabriquées dans un matériau plat.

9. Armoire selon la Revendication 7 ou 8, ***caractérisée en ce que*** les pièces d'angle de socle (33) sont fabriquées à partir d'un matériau métallique plat d'un seul tenant.

10. Armoire selon l'une des Revendications 7 à 9, ***caractérisée en ce que*** les pièces d'angle de socle (33) présentent deux flancs (34) repliés à angle droit avec des barres de soutien verticales (36) à deux couches, sur lesquelles s'appuie une partie profilée supérieure (35) de la pièce d'angle de socle (33).

11. Armoire selon la Revendication 10, ***caractérisée en ce que*** la partie de profilé supérieure (35) est un profilé en U ouvert vers le haut avec un logement d'angle (45) formé par un évidement dans le matériau plat, profilé qui forme avec un profilé inférieur en U (39) une section approximativement en S de la pièce d'angle de socle (33).

12. Armoire selon les Revendications 7 à 11, ***caractérisée en ce que***, sur les flancs (34) des pièces d'angle de socle (33), des brides de liaison (37) sont formées pour s'introduire dans des éléments de socle (31) reliant les pièces d'angle de socle (33).

13. Armoire selon l'une des Revendications précédentes, ***caractérisée en ce que*** les parois latérales (15) et/ou la paroi arrière (13) présentent des barres de bord en angle (17), qui saisissent par l'arrière un évidement, en particulier une rainure en T, des barres profilées supérieures et horizontales (4) ou des barres profilées transversales (6), et ***en ce qu'***une étanchéité s'établit au niveau des baguettes profilées (41) contre la paroi intérieure des barres profilées (2, 4, 6).

14. Armoire selon l'une des Revendications précédentes, ***caractérisée en ce qu'au*** moins les parois latérales (15) présentent des fermetures rapides (43) latérales et des tourniquets côté sol, qui sont munis en particulier de cylindres de fermeture (44).

15. Armoire selon l'une des Revendications précédentes, ***caractérisée en ce que*** les barres profilées (2, 4, 6) sont constituées de profilés extrudés coupés en longueur et ***en ce que***, sur les barres profilées verticales (2) et/ou sur les barres profilées horizontales (6), peuvent se fixer des rails multifonction (46), en particulier dans la zone centrale des parois latérales (15).
